# EUROPÄISCHE PATENTANMELDUNG

(11) **EP 1 784 071 A1**
(43) Veröffentlichungstag der Anmeldung: **09.05.2007**
(21) Anmeldenummer: 06022476.3
(22) Anmeldetag: 27.10.2006
(51) Int. Cl.: H05K 13/00, G03F 9/00, B23B 35/00

(54) **Vorrichtung zum Vorbereiten einer Mehrschicht- Leiterplatte auf das Bohren von Kontaktierungsbohrungen**

(30) Priorität: 08.11.2005 DE 102005053202
(71) Anmelder: COMET GmbH, 30827 Garbsen (DE)
(72) Erfinder: Reinhold, Alfred, 31515 Wunstorf (DE)
(74) Vertreter: Wagner, Carsten

(57) **Zusammenfassung**

Eine erfindungsgemäße Vorrichtung 24 zum Vorbereiten einer Mehrschicht-Leiterplatte 2 auf das Bohren von Kontaktierungsbohrungen 22, die Kontaktflächen wenigstens einer ersten Schicht 4 der Mehrschicht-Leiterplatte 2 mit Kontaktflächen wenigstens einer zweiten Schicht 6 der Mehrschicht-Leiterplatte 2 miteinander verbinden, weist Mittel zur Ermittlung eines Lagenversatzes zwischen der ersten Schicht 4 und der zweiten Schicht 6 der Mehrschicht-Leiterplatte 2 auf. Erfindungsgemäß weist die Vorrichtung Mittel zur Anbringung wenigstens einer Referenzmarke 30, 32, 34 an der Mehrschicht-Leiterplatte 2 und Mittel zur Ermittlung von Bohrkoordinaten der Kontaktierungsbohrungen 22 relativ zu der Referenzmarke 30 und in Abhängigkeit von dem ermittelten Lagenversatz auf.

## Beschreibung

Die Erfindung betrifft eine Vorrichtung der im Oberbegriff des Anspruchs 1 genannten Art zum Vorbereiten einer Mehrschicht-Leiterplatte auf das Bohren von Kontaktierungsbohrungen, die Kontaktflächen wenigstens einer ersten Schicht der Mehrschicht-Leiterplatte mit Kontaktflächen wenigstens einer zweiten Schicht der Mehrschicht-Leiterplatte miteinander verbinden.

Im Zuge einer zunehmenden Miniaturisierung elektronischer Baugruppen ist es erforderlich, auf einer vorgegebenen Fläche beispielsweise einer Leiterplatte eine immer größere Anzahl von Bauelementen bzw. Leiterbahnen vorzusehen. Aus diesem Grunde ist es bekannt, Leiterplatten als sogenannte Mehrschicht- oder Multilayer-Leiterplatten auszulegen, bei der die Leiterplatte aus einer Mehrzahl von schichtartig übereinander angeordneten einzelnen Leiterplatten besteht, so daß Bauteile oder Leiterbahnen auf der Vorder- und Rückseite der einzelnen Leiterplatten und damit aufgrund des schichtartigen Aufbaus auch zwischen den in der Schichtung aufeinanderfolgenden einzelnen Leiterplatten angeordnet sein können. Auf diese Weise ist es insbesondere möglich, Leiterplatten mit einer besonders hohen Anzahl von Leiterbahnen zu realisieren, die auf einer einzelnen Leiterplatte nicht untergebracht werden können. Die einzelnen Leiterplatten, deren Schichtung eine Mehrschicht-Leiterplatte bildet, werden, beispielsweise durch Verpressen oder Verkleben, fest miteinander verbunden.

Um eine Übertragung elektrischer Signale beispielsweise zwischen einer ersten Schicht und einer zweiten Schicht der Mehrschicht-Leiterplatte zu erzielen, ist es erforderlich, die Leiterbahnen der Schichten elektrisch leitend miteinander zu verbinden. Hierzu weisen die Schichten Kontaktierungsflächen auf, die auch als Pads bezeichnet werden. Die Kontaktierungsflächen können beispielsweise senkrecht zur Leiterplattenebene der Mehrschicht-Leiterplatte übereinanderliegend auf den Schichten angeordnet sein. Zum elektrisch leitenden Verbinden der Kontaktierungsflächen werden Kontaktierungsbohrungen gebohrt, wobei die Kontaktierungsbohrungen die Kontaktierungsflächen mechanisch miteinander verbinden, so daß die elektrisch leitende Verbindung beispielsweise dadurch hergestellt werden kann, daß die Innenwandungen der Kontaktierungsbohrungen mit Lot oder einem anderen elektrisch leitfähigen Material elektrisch leitend gemacht werden.

Die Kontaktierungsbohrungen müssen hierbei so ausgeführt werden, daß in der gewünschten Weise ein elektrisch leitender Kontakt zwischen den Kontaktierungsflächen ermöglicht ist. Dies ist ohne weiteres dann möglich, wenn die Kontaktierungsflächen senkrecht zur Leiterplattenebene der Mehrschicht-Leiterplatte exakt übereinanderliegend angeordnet sind. Zu berücksichtigen ist jedoch, daß beim Verbinden der Schichten der Mehrschicht-Leiterplatte, beispielsweise durch Verpressen, ein hoher Flächendruck in Verbindung mit hohen Temperaturen verwendet wird. Aufgrunddessen kann bei der Verbindung der Schichten ein Lagenversatz zwischen denselben auftreten. Ein solcher Lagenversatz kann darauf beruhen, daß die einzelnen Schichten schrumpfen oder sich dehnen und/oder sich parallel zur Leiterplattenebene relativ zueinander verschieben und/oder sich um eine senkrecht zur Leiterplattenebene verlaufende Achse relativ zueinander verdrehen.

Aufgrund eines auf diese Weise aufgetretenen Lagenversatzes ist es nicht mehr möglich, die elektrisch leitende Verbindung zwischen den Kontaktierungsflächen der Schichten durch die Kontaktierungsbohrungen zu bilden, sofern der Lagenversatz außerhalb vorgegebener Toleranzen liegt. Die Leiterplatte muß dann als Ausschuß verworfen werden.

Um zu verhindern, daß Leiterplatten, bei denen der Lagenversatz außerhalb der vorgegebenen Toleranzen liegt, einer kostenaufwendigen Weiterbearbeitung, beispielsweise beim Bestücken mit Bauteilen, unterzogen werden, ist es aus der DE 33 42 564 C2 bekannt, den Lagenversatz unter Verwendung einer Röntgen-Meßeinrichtung zu ermitteln.

Eine bekannte Bohrvorrichtung zum Bohren von Kontaktierungsbohrungen zum Verbinden von Kontaktierungsflächen wenigstens einer ersten Schicht einer Mehrschicht-Leiterplatte mit Kontaktierungsflächen wenigstens einer zweiten Schicht der Mehrschicht-Leiterplatte weist Bohrmittel zum Bohren der Kontaktierungsbohrungen und Steuermittel zur Erzeugung von Steuersignalen zur Ansteuerung der Bohrmittel entsprechend den jeweils zu bohrenden Kontaktierungbohrungen auf. Zur Fixierung der Mehrschicht-Leiterplatte, die nachfolgend kurz als Leiterplatte bezeichnet wird, in der Bohrvorrichtung weist die Leiterplatte Aufnahmelöcher auf, mit denen sie auf entsprechende an einem Träger, beispielsweise einem Bohrtisch, der Bohrvorrichtung vorgesehene Aufnahmestifte aufsteckbar ist. Durch die Position der Aufnahmelöcher ist somit die Position der Leiterplatte relativ zu dem Träger festgelegt.

In diesem Zusammenhang ist es bekannt, die Position der Aufnahmelöcher in der Leiterplatte zur Kompensation eines aufgetretenen Lagenversatzes zu korrigieren. Hierzu wird die Leiterplatte in eine Röntgen-Meßeinrichtung eingebracht, so daß ein etwaiger Lagenversatz zwischen den Schichten der Leiterplatte ermittelt werden kann, wie beispielsweise aus der DE 33 42 564 C2 bekannt. Falls ein Lagenversatz ermittelt wird, so kann die Position der Aufnahmelöcher so gewählt werden, daß der Lagenversatz beim nachfolgenden Bohren der Kontaktierungsbohrungen vollständig oder teilweise kompensiert wird, sofern der Lagenversatz innerhalb bestimmter Grenzen liegt.

Nach der Ermittlung des Lagenversatzes und dem Bohren der Aüfnahmelöcher in der Leiterplatte wird die Leiterplatte aus der Röntgen-Meßeinrichtung entnommen und in die Bohrvorrichtung eingebracht, wo sie auf die Aufnahmestifte des Trägers aufgesteckt wird. Daran anschließend bohren die Bohrmittel der Bohrvorrichtung die gewünschten Kontaktierungsbohrungen.

Der Erfindung liegt die Aufgabe zugrunde, eine Vorrichtung der im Oberbegriff des Anspruchs 1 genannten Art anzugeben, mittels derer eine Mehrschicht-Leiterplatte so vorbereitbar ist, daß beim nachfolgenden Bohren der Kontaktierungsbohrungen in einer Bohrvorrichtung die Positionsgenauigkeit der Kontaktierungsbohrungen erhöht ist.

Diese Aufgabe wird durch die im Anspruch 1 angegebene Lehre gelöst.

Der Grundgedanke der erfindungsgemäßen Lehre besteht darin, die Bohrkoordinaten der Kontaktierungsbohrungen relativ zu einer vorzugsweise und insbesondere optisch detektierbaren Referenzmarke zu ermitteln, die durch geeignete Mittel an der Mehrschicht-Leiterplatte, die nachfolgend auch kurz als Leiterplatte bezeichnet wird, anbringbar ist. Erfindungsgemäß sind die Bohrkoordinaten also nicht mehr absolut definiert, beispielsweise entsprechend einem Koordinatensystem der Bohrvorrichtung, sondern relativ zu der Referenzmarke. Daraus ergibt sich erfindungsgemäß, daß die Bohrkoordinaten auch nach beliebigen Lageänderungen der Leiterplatte die Position der gewünschten Kontaktierungsbohrungen relativ zu der Referenzmarke eindeutig definieren. Nach Detektion der Referenzmarke können die Kontaktierungsbohrungen somit unter Heranziehung der Bohrkoordinaten gebohrt werden.

Auf diese Weise ist die Position der Kontaktierungsbohrungen nicht mehr von mechanischen Toleranzen abhängig, die beim Stand der Technik beim Bohren der Aufnahmelöcher und beim Aufsetzen der Leiterplatte auf Aufnahmestifte eines Trägers einer Bohrvorrichtung die Positionsgenauigkeit der Kontaktierungsbohrungen beeinflussen. Auf diese Weise ist die Positionsgenauigkeit der Kontaktierungsbohrungen wesentlich erhöht.

Beim Bilden von Kontaktierungsbohrungen in einer Leiterplatte wird diese zunächst in einer erfindungsgemäßen Vorrichtung dadurch auf das Bohren der Kontaktierungsbohrungen vorbereitet, daß zunächst ein Lagenversatz zwischen den Schichten der Mehrschicht-Leiterplatte ermittelt wird. Außerdem wird an der Leiterplatte wenigstens eine Referenzmarke angebracht. Die Bohrkoordinaten der Kontaktierungsbohrungen werden dann relativ zu der Referenzmarke und in Abhängigkeit von dem ermittelten Lagenversatz ermittelt.

Daran anschließend kann die Leiterplatte aus der erfindungsgemäßen Vorrichtung entnommen und in eine Bohrvorrichtung eingebracht werden. In der Bohrvorrichtung wird dann zunächst die Position der Referenzmarke oder der Referenzmarken detektiert. Daran anschließend werden Bohrmittel der Bohrvorrichtung mit Steuersignalen angesteuert, die die in der erfindungsgemäßen Vorrichtung ermittelten Bohrkoordinaten relativ zu der Referenzmarke enthalten, derart, daß die Bohrmittel die Kontaktierungsbohrungen relativ zu der detektierten Position der Referenzmarke bohren.

Größe und Anzahl der Referenzmarke oder der Referenzmarken sind in weiten Grenzen wählbar. Erfindungsgemäß ist es grundsätzlich ausreichend, wenn eine einzige Referenzmarke an der Leiterplatte angebracht wird. Es ist erfindungsgemäß jedoch auch möglich, mehrere entlang der Oberfläche der Leiterplatte zueinander beabstandete Referenzmarken anzubringen. Bei einer solchen Ausführungsform ist es erfindungsgemäß insbesondere möglich, beim Vorbereiten der Leiterplatte den Abstand der Referenzmarken zueinander zu ermitteln. Nach Detektion der Referenzmarken und Ermittlung ihres Abstandes zueinander ist dann beispielsweise in einer Bohrvorrichtung ermittelbar, ob sich der Abstand der Referenzmarken zueinander verändert hat, es also zu einer Dehnung, Schrumpfung oder anders gearteten Veränderung an der Leiterplatte gekommen ist. Entsprechend der festgestellten Änderung können dann ggf. die Bohrkoordinaten korrigiert werden. Wird demgegenüber festgestellt, daß sich die Lage der Referenzmarken relativ zueinander und/oder ihre Größe nicht geändert haben, so können die Bohrkoordinaten relativ zu der Referenzmarke zum Bohren der Kontaktierungsbohrungen ohne Korrektur verwendet werden.

Auch die Form der Referenzmarke oder der Referenzmarken ist in weiten Grenzen wählbar. Als Referenzmarken können beispielsweise Strichmarkierungen oder geometrische Gebilde verwendet werden. Anhand einer rotationsasymmetrischen Referenzmarke ist insbesondere die Drehlage der Leiterplatte senkrecht zur Leiterplattenebene feststellbar.

Erfindungsgemäß können die Mittel zur Anbringung wenigstens einer Referenzmarke auf beliebige geeignete Weise ausgebildet sein. Eine außerordentlich vorteilhafte Weiterbildung der erfindungsgemäßen Lehre sieht vor, daß die Mittel zur Anbringung wenigstens einer Referenzmarke wenigstens einen Laser aufweisen, mittels dessen Laserstrahl die Referenzmarke an der Mehrschicht-Leiterplatte anbringbar ist. Geeignete Markierungslaser stehen als relativ einfache und kostengünstige Standardbaugruppen zur Verfügung. Sie ermöglichen eine hochpräzise Markierung der Leiterplatte mit der Referenzmarke.

Die erfindungsgemäß verwendete Referenzmarke kann auf beliebige geeignete Weise detektierbar sein. Es kann sich beispielsweise um eine elektrisch oder mechanisch detektierbare Markierung handeln. Eine außerordentlich vorteilhafte Weiterbildung der erfindungsgemäßen Lehre sieht jedoch vor, daß wenigstens eine Referenzmarke eine optisch detektierbare Markierung ist. Auf diese Weise ist die Detektion der Referenzmarke besonders einfach gestaltet.

Grundsätzlich ist es erfindungsgemäß möglich, die Referenzmarke im Inneren einer Mehrschicht-Leiterplatte anzubringen. Um die Detektion der Referenzmarke besonders einfach und effizient zu gestalten, sieht eine vorteilhafte Weiterbildung der erfindungsgemäßen Lehre vor, daß die Mittel zur Anbringung wenigstens einer Referenzmarke die Referenzmarke oder die Referenzmarken auf der Oberfläche der Mehrschicht-Leiterplatte anbringen.

Eine andere vorteilhafte Weiterbildung der erfindungsgemäßen Lehre sieht vor, daß die Mittel zur Ermittlung eines Lagenversatzes den Lagenversatz mittels eines bildgebenden Verfahrens ermitteln.

Um die Ermittlung des Lagenversatzes besonders genau und effizient zu gestalten, sieht eine vorteilhafte Weiterbildung der vorgenannten Ausführungsform vor, daß die Mittel zur Ermittlung des Lagenversatzes wenigstens eine Röntgen-Meßeinrichtung zur Messung des Lagenversatzes aufweisen, wobei gemäß einer vorteilhaften Weiterbildung die Röntgen-Meßeinrichtung wenigstens eine Mikrofokus-Röntgenröhre aufweist.

Bei den erfindungsgemäß ermittelten Bohrkoordinaten kann es sich um zweidimensionale Koordinaten handeln, die die Lage der Kontaktierungsbohrungen in x-und y-Richtung entlang der Leiterplattenoberfläche definieren. Es kann sich jedoch auch um dreidimensionale Koordinaten handeln, die neben der Position der Kontaktierungsbohrungen in x- und y-Richtung beispielsweise auch die Tiefe der jeweiligen Kontaktierungsbohrung definieren.

Eine insbesondere zur Verwendung mit der erfindungsgemäßen Vorrichtung vorgesehene Bohrvorrichtung zum Bohren von Kontaktierungsbohrungen ist im Anspruch 8 angegeben.

Erfindungsgemäß weist die Bohrvorrichtung Mittel zur Detektion der Position wenigstens einer an der Mehrschicht-Leiterplatte angebrachten Referenzmarke auf, wobei die Steuermittel die Bohrmittel mit Steuersignalen ansteuern, die Bohrkoordinaten der Kontaktierungsbohrungen relativ zu der Referenzmarke enthalten, derart, daß die Bohrmittel die Kontaktierungsbohrungen relativ zu der detektierten Position der Referenzmarke bohren. Die erfindungsgemäße Bohrvorrichtung ermöglicht somit das Bohren der Kontaktierungsbohrungen mit hoher Positionsgenauigkeit unter völliger oder weitestgehender Ausschaltung mechanischer Toleranzen.

Eine vorteilhafte Weiterbildung der erfindungsgemäßen Bohrvorrichtung sieht vor, daß die Sensormittel wenigstens einen optischen Sensor zum Detektieren einer optisch detektierbaren Markierung aufweisen, wobei der optische Sensor vorzugsweise durch eine Kamera gebildet ist. Bei diesen Ausführungsformen ist die Detektion der Referenzmarke oder der Referenzmarken mit geringem apparativen Aufwand mit besonders hoher Präzision ermöglicht.

Eine außerordentlich vorteilhafte Weiterbildung der erfindungsgemäßen Bohrvorrichtung sieht vor, daß die Bohrmittel wenigstens einen Laser zum Bohren der Kontaktierungsbohrungen aufweisen. Mittels eines Lasers können die Kontaktierungsbohrungen mit besonders hoher Präzision sowie besonders schnell gebohrt werden.

Ein erfindungsgemäßes System zum Bohren von Kontaktierungsbohrungen zum Verbinden von Kontaktierungsflächen wenigstens einer ersten Schicht einer Mehrschicht-Leiterplatte mit Kontaktierungsflächen wenigstens einer zweiten Schicht der Mehrschicht-Leiterplatte ist im Anspruch 12 definiert.

Es weist eine Vorrichtung nach einem der Ansprüche 1 bis 7 und eine Bohrvorrichtung nach einem der Ansprüche 8 bis 11 auf. In dem erfindungsgemäßen System stehen die Mittel zur Ermittlung der Bohrkoordinaten der Kontaktierungsbohrungen relativ zu der Referenzmarke mit den Steuermitteln in Signalübertragungsverbindung und übermitteln den Steuermitteln in Bezug auf eine zu bearbeitende Mehrschicht-Leiterplatte einen Datensatz, der die Bohrkoordinaten der Kontaktierungsbohrungen relativ zu der Referenzmarke enthält. Erfindungsgemäß steuern die Steuermittel die Bohrmittel unter Heranziehung der Bohrkoordinaten an, derart, daß die Bohrmittel die Kontaktierungsbohrungen relativ zu der detektierten Position der Referenzmarke bohren. In dem erfindungsgemäßen System sind die Vorrichtung zum Vorbereiten der Mehrschicht-Leiterplatte und die Bohrvorrichtung vorzugsweise räumlich voneinander getrennte, separate Vorrichtungen.

Die Erfindung wird nachfolgend anhand der beigefügten stark schematisierten Zeichnung näher erläutert, die ein Ausführungsbeispiel einer erfindungsgemäßen Bohrvorrichtung zur Durchführung des erfindungsgemäßen Verfahrens darstellt. Dabei bilden alle beanspruchten, beschriebenen oder in der Zeichnung dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

Es zeigt:
- Fig. 1: in perspektivischer, stark schematisierter Darstellung die Schichten einer Mehrschicht-Leiterplatte vor dem Verbinden der Schichten miteinander,
- Fig. 2: einen Vertikalschnitt durch die Leiterplatte gemäß Fig. 1, wobei aus Darstellungsgründen lediglich zwei Schichten gezeigt sind und wobei eine Kontaktierungsbohrung gezeigt ist, deren Innenwandung mit einem elektrisch leitfähigen Material versehen ist,
- Fig. 3: eine Ansicht von oben auf die Leiterplatte gemäß Fig. 2 ohne Lagenversatz der Schichten der Leiterplatte zueinander,
- Fig. 4: in gleicher Darstellung wie Fig. 3 die Leiterplatte gemäß Fig. 2 bei einem ersten Lagenversatz der Schichten zueinander,
- Fig. 5: in gleicher Darstellung wie Fig. 3 die Leiterplatte gemäß Fig. 2 bei einem zweiten Lagenversatz der Schichten zueinander,
- Fig. 6: in Seitenansicht eine Prinzipskizze einer erfindungsgemäßen Vorrichtung zum Vorbereiten einer Mehrschicht-Leiterplatte auf das Bohren von Kontaktierungsbohrungen,
- Fig. 7: eine schematische Draufsicht auf eine mit Referenzmarken versehene Mehrschicht-Leiterplatte,
- Fig. 8: in gleicher Darstellung wie Fig. 6 eine erfindungsgemäße Bohrvorrichtung zum Bohren von Kontaktierungsbohrungen und
- Fig. 9: einen Signalflußplan eines erfindungsgemäßen Systems, bestehend aus einer Vorrichtung gemäß Fig. 6 und einer Bohrvorrichtung gemäß Fig. 8.

In den Figuren der Zeichnung sind gleiche bzw. sich entsprechende Bauteile mit den gleichen Bezugszeichen versehen.

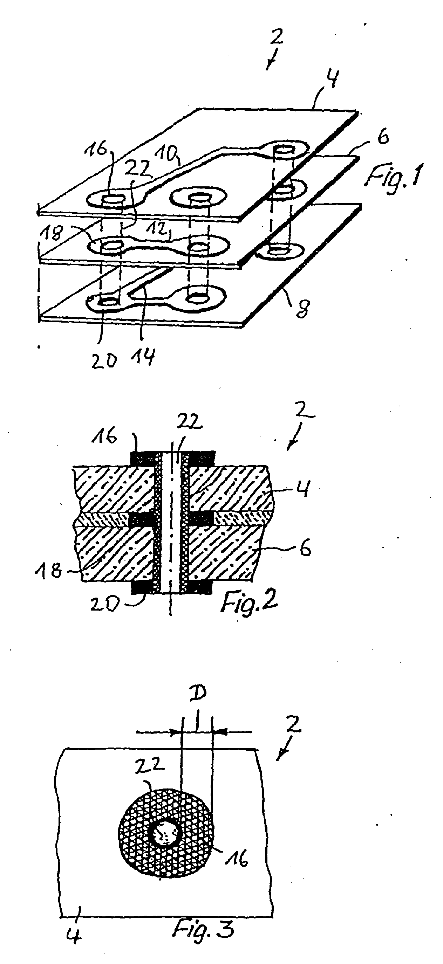

In Fig. 1 ist stark schematisiert eine Mehrschicht-Leiterplatte 2 dargestellt, die nachfolgend kurz als Leiterplatte bezeichnet wird. Die Leiterplatte 2 weist einen schichtartigen Aufbau auf, wobei Schichten 4, 6, 8 der Leiterplatte 2 jeweils durch eine einzelne Leiterplatte gebildet sind. Die Schichten 4, 6, 8 der Leiterplatte 2 sind fest miteinander verbunden, beispielsweise durch Verpressen.oder Verkleben. Aus Darstellungsgründen sind die Schichten 4, 6, 8 in Fig. 1 im nicht miteinander verbundenen Zustand gezeigt. Lediglich beispielshalber besteht die Leiterplatte 2 gemäß Fig. 1 aus drei Schichten. Die Zahl der Schichten ist jedoch in weiten Grenzen wählbar. Die Leiterplatte 2 kann beispielsweise aus lediglich zwei Schichten oder auch aus mehr als drei Schichten bestehen.

Im Fertigungszustand der Leiterplatte 2 weisen die Schichten 4, 6, 8 Leiterbahnen auf, von denen in Fig. 1 eine Leiterbahn der Schicht 4 mit den Bezugszeichen 10, eine Leiterbahn der Schicht 6 mit dem Bezugszeichen 12 und eine Leiterbahn der Schicht 8 mit dem Bezugszeichen 14 versehen ist. Die Leiterbahnen 10, 12, 14 bestehen aus einem elektrisch leitfähigen Material und sind mit Kontaktierungsflächen 16 bzw. 18 bzw. 20 aus elektrisch leitfähigem Material verbunden, die bei diesem Ausführungsbeispiel in der Draufsicht im wesentlichen kreisförmig ausgebildet sind. Die Kontaktierungsflächen 16, 18, 20 sind durch eine Kontaktierungsbohrung miteinander verbindbar, die in Fig. 1 bei dem Bezugszeichen 22 angedeutet ist.

Fig. 2 zeigt einen Vertikalschnitt durch die Leiterplatte 2 gemäß Fig. 1. Zum elektrisch leitenden Verbinden der Kontaktierungsflächen 16, 18, 20 wird die Leiterplatte 2 so durchbohrt, daß die Kontaktierungsbohrung 22 im Idealfall koaxial zu den Kontaktierungsflächen 16, 18, 20 verläuft. Nach dem Bohren der Kontaktierungsbohrung 22 wird deren Innenwandung mit einem elektrisch leitfähigen Material, beispielsweise einem Lot, versehen, das in der gewünschten Weise eine elektrisch leitende Verbindung zwischen den Kontaktierungsflächen 16, 18, 20 herstellt.

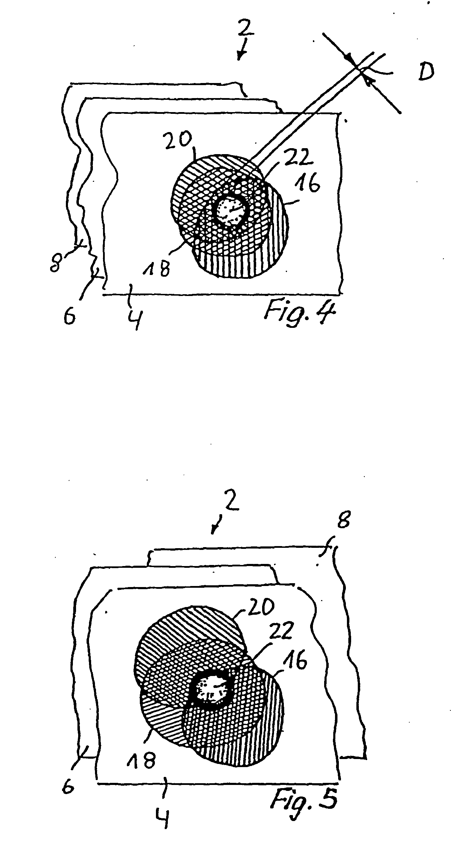

Fig. 3 zeigt eine Draufsicht auf die Leiterplatte 2 gemäß Fig. 2. Beim Verbinden der Schichten 4, 6, 8 miteinander kann ein Lagenversatz der Schichten 4, 6, 8 relativ zueinander auftreten, aufgrund dessen die Kontaktierungsflächen 16, 18, 20 dann nicht mehr in der gewünschten Weise senkrecht zur Leiterplattenebene exakt übereinanderliegen. Ein Lagenversatz kann insbesonder durch eine Dehnung oder Schrumpfung wenigstens einer der Schichten 4, 6, 8, durch eine Verschiebung der Schichten 4, 6, 8 parallel zur Leiterplattenebene relativ zueinander und/oder eine Verdrehung der Schichten 4, 6, 8 relativ zueinander um eine senkrecht zur Leiterplattenebene verlaufende Achse und/oder durch eine Scherung auftreten. Fig. 3 stellt eine Leiterplatte 2 dar, bei der ein solcher Lagenversatz nicht aufgetreten ist, so daß die Kontaktierungsflächen 16, 18, 20 senkrecht zur Leiterplattenebene aufeinanderfolgend übereinanderliegen. Wie aus Fig. 3 ersichtlich ist, sind die Kontaktierungsflächen 16, 18, 20 nach dem Bilden der Kontaktierungsbohrung 22 im wesentlichen ringförmig, wobei in diesem Falle die Kontaktierungsbohrung 22 in der gewünschten Weise koaxial zu den Kontaktierungsflächen 16, 18, 20 verläuft. Die ringförmigen Kontakierungsflächen 16, 18, 20 haben eine radiale Breite D.

Fig. 4 stellt eine Leiterplatte 2 dar, bei der ein Lagenversatz aufgetreten ist, aufgrunddessen die Kontaktierungsbohrung 22 nicht mehr zu sämtlichen Kontaktierungsflächen 16, 18, 20 koaxial ist. Die Position der Kontaktierungsbohrung 22 wird hierbei so gewählt, daß sich für sämtliche Kontaktierungsflächen 16, 18, 20 eine möglichst große verbleibende radiale Breite D ergibt. Unterschreitet die verbleibende radiale Breite D der Kontaktierungsflächen 16, 18, 20 einen vorbestimmten Wert, so kann die Leiterplatte 2 nicht weiterverwendet werden und muß verworfen werden.

Fig. 5 stellt eine Leiterplatte 2 dar, bei der ein Lagenversatz aufgetreten ist, der so groß ist, daß auch nach Optimierung der Position der Kontaktierungsbohrung 22 nicht sichergestellt werden kann, daß sämtliche Kontaktierungsflächen 16, 18, 20 ringförmig mit einer vorgegebenen minimalen radialen Breite sind. Vielmehr sind bei der in Fig. 5 dargestellten Leiterplatte die Kontaktierungsflächen 16, 18 nach dem Bohren der Kontaktierungsbohrung nicht mehr ringförmig, sondern in Radialrichtung an ihrem äußeren Umfang unterbrochen. Auch eine solche Leiterplatte kann nicht weiterverwendet werden, sondern muß verworfen werden.

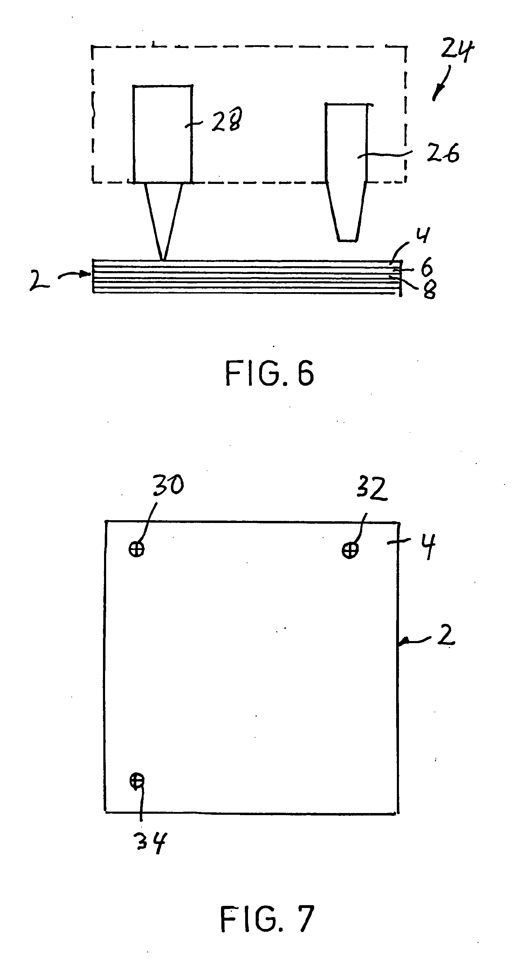

In Fig. 6 ist eine Prinzipskizze einer erfindungsgemäßen Vorrichtung 24 zum Vorbereiten einer Mehrschicht-Leiterplatte 2 auf das Bohren von Kontaktierungsbohrungen dargestellt, die wenigstens eine erste Schicht 4 der Leiterplatte mit Kontaktflächen wenigstens einer zweiten Schicht 6 der Leiterplatte miteinander verbinden. Die Vorrichtung 4 weist Mittel zur Ermittlung eines Lagenversatzes zwischen den Schichten 4, 6, 8 und den weiteren in der Zeichnung nicht mit einem Bezugszeichen versehenen Schichten der Leiterplatte 2 auf, die bei diesem Ausführungsbeispiel eine Mikrofocus-Röntgenröhre 26 aufweisen, durch die mittels eines bildgebenden Verfahrens ein Lagenversatz der Schichten 4, 6, 8 und der weiteren Schichten der Leiterplatte 2 zueinander ermittelbar ist. Die Art und Weise der Ermittlung des Lagenversatzes durch Röntgenuntersuchung der Leiterplatte 2 ist dem Fachmann allgemein bekannt und wird daher hier nicht näher erläutert.

Erfindungsgemäß weist die Vorrichtung 24 Mittel zur Anbringung wenigstens einer Referenzmarke an der Leiterplatte 2 auf, wobei diese Mittel bei dieser Ausführungsform einen Laser 28 aufweisen, mittels dessen Laserstrahlung die Referenzmarke oder Referenzmarken an der Leiterplatte 2 anbringbar ist bzw. sind. Jede der Referenzmarken ist bei diesem Ausführungsbeispiel eine optisch detektierbare Markierung.

Die Vorrichtung 24 weist erfindungsgemäß ferner in Fig. 6 nicht dargestellte Mittel zur Ermittlung von Bohrkoordinaten der Kontaktierungsbohrungen relativ zu der Referenzmarke und in Abhängigkeit von dem ermittelten Lagenversatz auf.

Zum Vorbereiten einer Leiterplatte 2 auf das Bohren der Kontaktierungbohrungen wird die Leiterplatte 2 ortsfest gehalten und der Lagenversatz der Schichten der Leiterplatte 2 relativ zueinander mittels der Mikrofocus-Röntgenröhre 26 ermittelt, die hierbei die relevante Oberfläche der Leiterplatte 2 abtastet. Die Mikrofocus-Röntgenröhre ist dementsprechend in X- und Y-Richtung, also in Fig. 6 parallel zur Zeichenebene sowie in die Zeichenebene hinein bzw. aus der Zeichenebene heraus beweglich gelagert.

Erfindungsgemäß wird mittels des Lasers 28 wenigstens eine Referenzmarke in Form einer optisch detektierbaren Markierung auf die Oberfläche der Leiterplatte 2 aufgebracht.

Daran anschließend werden durch die Mittel zur Ermittlung von Bohrkoordinaten der Kontaktierungsbohrungen diese Bohrkoordinaten relativ zu der Referenzmarke und in Abhängigkeit von dem ermittelten Lagenversatz ermittelt. Hierzu kann eine geeignete Steuervorrichtung vorgesehen sein, die beispielsweise einen PC aufweisen kann und die Bohrkoordinaten optimiert und relativ zu der Referenzmarke sowie in Abhängigkeit von dem ermittelten Lagenversatz ermittelt. Die ermittelten Bohrkoordinaten, die die Positionen der zu bohrenden Kontaktierungsbohrungen relativ zu der Referenzmarke definieren, können dann als der Leiterplatte 2 zugeordneter Datensatz in einem Speicher abgespeichert werden.

Fig. 7 zeigt eine Draufsicht auf die Leiterplatte 2, auf deren Oberfläche bei diesem Ausführungsbeispiel drei zueinander beabstandete Referenzmarken 30, 32, 34 angebracht sind.

Nach dem Vorbereiten der Leiterplatte 2 auf das Bohren der Kontaktierungsbohrungen kann die Leiterplatte 2 aus der erfindungsgemäßen Vorrichtung 24 entnommen und in eine erfindungsgemäße Bohrvorrichtung eingebracht werden.

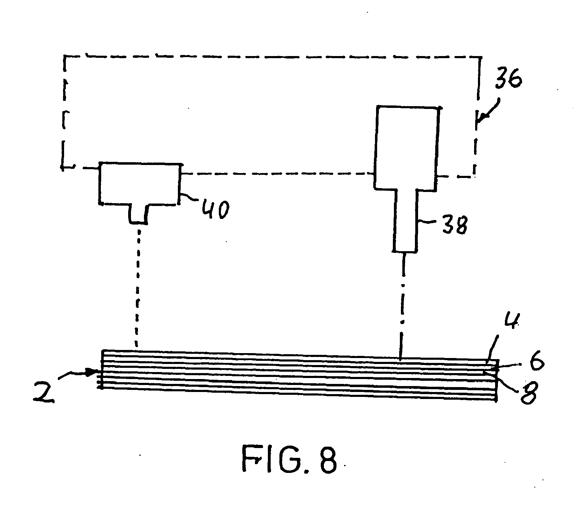

Fig. 8 stellt eine Prinzipskizze einer erfindungsgemäßen Bohrvorrichtung 36 dar. Die erfindungsgemäße Bohrvorrichtung 36 weist Bohrmittel zum Bohren der Kontaktierungsbohrungen auf, die bei diesem Ausführungsbeispiel einen Laser 38 aufweisen, mittels dessen die Kontaktierungsbohrungen mit hoher Positionsgenauigkeit und hoher geometrischer Genauigkeit in die Leiterplatte 2 gebohrt werden können.

Die erfindungsgemäße Bohrvorrichtung 36 weist ferner Mittel zur Detektion der Position der an der Leiterplatte 2 angebrachten Referenzmarken 30, 32, 34 auf, die bei diesem Ausführungsbeispiel einen optischen Sensor aufweisen, der durch eine CCD-Kamera 40 gebildet ist. Ferner weist die erfindungsgemäße Bohrvorrichtung 36 in Fig. 8 nicht dargestellte Steuermittel auf, die den Laser 38 mit Steuersignalen ansteuern, die die in der erfindungsgemäßen Vorrichtung 24 (vgl. Fig. 6) ermittelten Bohrkoordinaten der Kontaktierungsbohrungen relativ zu der Referenzmarke enthalten.

Zur Abtastung der Oberfläche der Leiterplatte 2 sind die CCD-Kamera 40 und der Laser 38 in X- und Y-Richtung, also parallel zur Zeichenebene sowie in die Zeichenebene hinein bzw. aus der Zeichenebene heraus, beweglich gelagert.

Während der Detektion der Position der Referenzmarken 30, 32, 34 und während des Bohrens der Kontaktierungsbohrungen wird die Leiterplatte 2 in der Bohrvorrichtung 36 ortsfest gehalten.

Nach der Detektion der Position der Referenzmarken 30, 32, 34 steuern die Steuermittel die Bohrmittel mit entsprechenden Steuersignalen an, die Bohrkoordinaten der Kontaktierungsbohrungen relativ zu den Referenzmarken enthalten, derart, daß die Bohrmittel die Kontaktierungsbohrungen relativ zu der detektierten Position der Referenzmarken 30, 32, 34 bohren.

Erfindungsgemäß werden somit die Kontaktierungsbohrungen an relativ zu der Position der Referenzmarken 30, 32, 34 definierten Positionen gebohrt, so daß die Positionsgenauigkeit der Kontaktierungsbohrungen von der absoluten Position der Leiterplatte 2 in der Bohrvorrichtung 36 unabhängig ist. Somit ist die Positionsgenauigkeit der Kontaktierungsbohrungen erfindungsgemäß nicht durch mechanische Gegebenheiten beeinflußt, sondern ausschließlich von der Genauigkeit der Detektion der Referenzmarken 30, 32, 34 und der Positioniergenauigkeit des Lasers 38 abhängig. Da sowohl die Detektion der Position der Referenzmarken 30, 32, 34 als auch die Positionierung des Lasers 38 relativ zu der Leiterplatte 2 hochpräzise erfolgen können, ist auf diese Weise eine außerordentlich hohe Positionsgenauigkeit der Kontaktierungsbohrungen erreicht.

Erfindungsgemäß können die relativ zu den Referenzmarken 30, 32, 34 ermittelten Bohrkoordinaten ohne weitere Korrektur zum Bohren der Kontaktierungsbohrungen herangezogen werden. Es ist erfindungsgemäß jedoch auch möglich, Positionsänderungen der Referenzmarken 30, 32, 34 zu ermitteln, um beispielsweise festzustellen, ob die Leiterplatte 2 nach der Ermittlung der Bohrkoordinaten geschrumpft ist oder sich gedehnt hat. Hierzu kann der zu der Bohrvorrichtung 36 übermittelte Datensatz beispielsweise eine Information über den Abstand der Referenzmarken 30, 32, 34 zueinander oder ihre Position relativ zueinander enthalten sein. Wird nach Ermittlung der Position der Referenzmarken 30, 32, 34 mittels der CCD-Kamera 40 in der erfindungsgemäßen Bohrvorrichtung 36 festgestellt, daß sich die Lage der Referenzmarken 30, 32, 34 geändert hat, beispielsweise aufgrund einer Dehnung oder Schrumpfung der Leiterplatte 2, so können die Bohrkoordinaten entsprechend verändert werden.

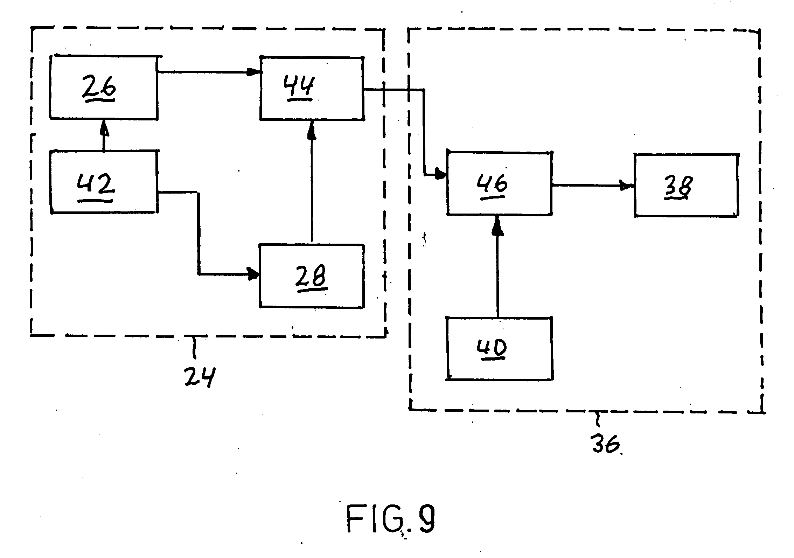

Fig. 9 stellt einen Signalflußplan eines aus einer erfindungsgemäßen Vorrichtung gemäß Fig. 6 und einer erfindungsgemäßen Bohrvorrichtung 8 bestehenden Systemes dar.

Eine Steuereinrichtung 42 steuert die Mikrofocus-Röntgenröhre zur Abtastung der Leiterplatte 2 zur Ermittlung des Lagenversatzes und den Laser 28 zum Anbringen der Referenzmarken 30, 32, 34 auf Leiterplatte 2 an. Die Position der Referenzmarken 30, 32, 34 und der ermittelte Lagenversatz werden zu Mitteln 44 zur Ermittlung der Bohrkoordinaten der Kontaktierungsbohrungen relativ zu den Referenzmarken 30, 32, 34 und in Abhängigkeit von dem ermittelten Lagenversatz übermittelt. Die Mittel 44 errechnen aus diesen Daten die Bohrkoordinaten der Kontaktierungsbohrungen relativ zu den Referenzmarken 30, 32, 34 und übermitteln einen entsprechenden Datensatz zu Steuermitteln 46 der erfindungsgemäßen Bohrvorrichtung 36. Die CCD-Kamera 40 ermittelt die Position der Referenzmarken 30, 32, 34 und übermittelt diese den Steuermitteln 46, die daraufhin den Laser 38 zum Bohren der Kontaktierungsbohrungen entsprechend den Bohrkoordinaten relativ zu den Referenzmarken 30, 32, 34 ansteuern.

## Patentansprüche

1. Vorrichtung zum Vorbereiten einer Mehrschicht-Leiterplatte auf das Bohren von Kontaktierungsbohrungen, die Kontaktflächen wenigstens einer ersten Schicht der Mehrschicht-Leiterplatte mit Kontaktflächen wenigstens einer zweiten Schicht der Mehrschicht-Leiterplatte miteinander verbinden,
mit Mitteln zur Ermittlung eines Lagenversatzes zwischen der ersten Schicht und der zweiten Schicht der Mehrschicht-Leiterplatte,
**gekennzeichnet durch**
Mittel zur Anbringung wenigstens einer Referenzmarke (30) an der Mehrschicht-Leiterplatte (2) und **durch**
Mittel zur Ermittlung von Bohrkoordinaten der Kontaktierungsbohrungen (22) relativ zu der Referenzmarke (30) und in Abhängigkeit von dem ermittelten Lagenversatz.

2. Vorrichtung nach Anspruch 1, **dadurch gekennzeichnet, daß** die Mittel zur Anbringung wenigstens einer Referenzmarke wenigstens einen Laser (28) aufweisen, mittels dessen Laserstrahl die Referenzmarke (30) an der Mehrschicht-Leiterplatte (2) anbringbar ist.

3. Vorrichtung nach Anspruch 1 oder 2, **dadurch gekennzeichnet, daß** wenigstens eine Referenzmarke (30) eine optisch detektierbare Markierung ist.

4. Vorrichtung nach einem der vorhergehenden Ansprüche, **dadurch gekennzeichnet, daß** die Mittel zur Anbringung wenigstens einer Referenzmarke (30) die Referenzmarke (30) oder die Referenzmarken (30, 32, 34) auf der Oberfläche der Mehrschicht-Leiterplatte (2) anbringen.

5. Vorrichtung nach einem der vorhergehenden Ansprüche, **dadurch gekennzeichnet, daß** die Mittel zur Ermittlung eines Lagenversatzes den Lagenversatz mittels eines bildgebenden Verfahrens ermitteln.

6. Vorrichtung nach einem der vorhergehenden Ansprüche, **dadurch gekennzeichnet, daß** die Mittel zur Ermittlung des Lagenversatzes wenigstens eine Röntgen-Meßeinrichtung zur Messung des Lagenversatzes aufweisen.

7. Vorrichtung nach Anspruch 6, **dadurch gekennzeichnet, daß** die Röntgen-Meßeinrichtung wenigstens eine Mikrofokus-Röntgenröhre (26) aufweist.

8. Bohrvorrichtung zum Bohren von Kontaktierungsbohrungen zum Verbinden von Kontaktierungsflächen wenistens einer ersten Schicht einer Mehrschicht-Leiterplatte mit Kontaktierungsflächen wenigstens einer zweiten Schicht einer Mehrschicht-Leiterplatte,
mit Bohrmitteln zum Bohren der Kontaktierungsbohrungen und
mit Steuermitteln zur Erzeugung von Steuersignalen zur Ansteuerung der Bohrmittel entsprechend den jeweils zu bohrenden Kontaktierungsbohrungen,
**gekennzeichnet durch**
Mittel zur Detektion der Position wenigstens einer an der Mehrschicht-Leiterplatte angebrachten Referenzmarke (30),
wobei die Steuermittel die Bohrmittel mit Steuersignalen ansteuern, die Bohrkoordinaten der Kontaktierungsbohrungen (22) relativ zu der Referenzmarke (30) enthalten, derart, daß die Bohrmittel die Kontaktierungsbohrungen (22) relativ zu der detektierten Position der Referenzmarke (30) bohren.

9. Bohrvorrichtung nach Anspruch 8, **dadurch gekennzeichnet, daß** die Sensormittel wenigstens einen optischen Sensor zum Detektieren einer optisch detektierbaren Markierung aufweisen.

10. Bohrvorrichtung nach Anspruch 9, **dadurch gekennzeichnet, daß** der optische Sensor durch eine Kamera (40) gebildet ist.

11. Bohrvorrichtung nach einem der Ansprüche 8 bis 10, **dadurch gekennzeichnet, daß** die Bohrmittel wenigstens einen Laser (38) zum Bohren der Kontaktierungsbohrungen (22) aufweisen.

12. System zum Bohren von Kontaktierungsbohrungen (22) zum Verbinden von Kontaktierungsflächen wenigstens einer ersten Schicht (4) einer Mehrschicht-Leiterplatte (2) mit Kontaktierungsflächen wenigstens einer zweiten Schicht (6) der Mehrschicht-Leiterplatte (2),
mit einer Vorrichtung (24) nach einem der Ansprüche 1 bis 7 zum Vorbereiten der Mehrschicht-Leiterplatte (2) auf das Bohren der Kontaktierungsbohrungen (22) und
mit einer Bohrvorrichtung (36) nach einem der Ansprüche 8 bis 11 zum Bohren der Kontaktierungsbohrungen (22),
wobei die Mittel zum Ermittlung der Bohrkoordinaten der Kontaktierungsbohrungen (22) relativ zu der Referenzmarke (30) mit den Steuermitteln in Signalübertragungsverbindung stehen und den Steuermitteln in Bezug auf eine zu bearbeitende Mehrschicht-Leiterplatte (2) einen Datensatz übermitteln, der die Bohrkoordinaten der Kontaktierungsbohrungen (22) relativ zu der Referenzmarke (30) enthält,
wobei die Steuermittel die Bohrmittel unter Heranziehung der Bohrköordinaten ansteuern, derart, daß die Bohrmittel die Kontaktierungsbohrungen (22) relativ zu der detektierten Position der Referenzmarke (30) bohren.
